# EUROPEAN PATENT APPLICATION

(11) **EP 2 871 681 A1**
(43) Date of publication of application: **13.05.2015**
(21) Application number: 13191972.2
(22) Date of filing: 07.11.2013
(51) Int. Cl.: H01L 31/0216, H01L 31/0224, H01L 31/0392, H01L 31/0749

(54) **Back contact substrate for a photovoltaic cell or module**

(71) Applicant: Saint-Gobain Glass France, 92400 Courbevoie (FR)
(72) Inventor: Urien, Mathieu, 94120 Fontenay Sous Bois (FR); Bokobza, Gilles, 75019 Paris (FR); Palm Jörg, 80797 Munich (DE); Ruitenberg, Gérard, 52134 Herzogenrath (DE); Graham, Andrew, 85635 Hohenkirchen-Sigertsbrunn (DE)
(74) Representative: Neuviale, Bertrand

(57) **Abstract**

Back-contact substrate (1) for a photovoltaic cell, comprising a carrier substrate (2) and an electrode coating (6). The electrode coating comprises:
- a metallic thin film (8);
- a barrier to selenization thin film (10) for protecting the metallic thin film (8), the barrier to selenization thin film (10) having a thickness of at most 50 nm, preferably at most 30 nm, preferably at most 20 nm; and
- on the barrier to selenization thin film(10), an upper thin film (12) based on a metal M capable of forming, after sulphurization and/or selenization, an ohmic contact thin film with a photoactive semiconducting material.

The metallic thin film (8) is based on aluminum and has a thickness of at most 300nm, preferably at most 100 nm, preferably at most 90 nm, preferably at most 80 nm.

## Description

The invention relates to the field of photovoltaic cells, more particularly to the field of non transparent back contact substrates used to manufacture thin film photovoltaic cells.

Specifically, in a known way, some thin film photovoltaic cells, referred to as second generation of photovoltaic devices, use a molybdenum-based back contact substrate coated with a thin light absorbing film (i.e., photoactive material), made of copper (Cu), indium (In), and selenium (Se) and/or sulphur (S) chalcopyrite. It can, for example, be a material of the CuInSe₂ type with a chalcopyrite structure. This type of material is known under the abbreviation CIS. It can also be CIGS, that is to say a material additionally incorporating gallium (Ga), or CIGSSe, that is to say a material incorporating both sulphur and selenium. A second class of materials is made of the Cu₂(Zn,Sn)(S,Se)₄ (i.e. CZTS) type with a Kesterite structure, using zinc and/or tin instead of indium and/or gallium. A third class is made of cadmium telluride (CdTe) and cadmium sulfide (CdS).

For the CIS, CIGS, CIGSSe and the CZTSSe types of applications, the back contact electrodes are generally based on molybdenum (Mo) because this material exhibits a number of advantages. It is a good electrical conductor (relatively low resistivity of the order of 10 µΩ.cm). It can be subjected to the necessary high heat treatments since it has a high melting point (2610°C). It withstands, to a certain extent, selenium and sulphur. The deposition of the thin film of absorbing agent generally requires contact with an atmosphere comprising selenium or sulphur at a high temperature, which tends to damage the majority of metals. Molybdenum reacts with selenium or sulphur, in particular, forming MoSe₂, MoS₂ or Mo(S,Se)₂, but remains conductive and forms an appropriate ohmic contact with the CIS, CIGS, CIGSSe, CZTS or CdTe thin films. Finally, it is a material on which thin films of CIS, CIGS, CIGSSe, CZTS or CdTe types adhere well; the molybdenum even tends to promote the crystal growth thereof.

However, molybdenum exhibits a major disadvantage for industrial production: it is an expensive material. The cost of the raw material is high compared to aluminum or copper. Molybdenum thin films are normally deposited by magnetic-field-assisted cathode sputtering (i.e. magnetron sputtering). As a matter of fact, the manufacturing of molybdenum targets is expensive, too. This is all the more important as, in order to obtain the desired level of electrical conductance (a resistance per square of at most 2 Ω/□ and preferably at most 1 Ω/□, even preferably at most 0.5 Ω/□ after treatment in an atmosphere containing S or Se), a relatively thick thin film of Mo, generally of the order of from 400 nm to 1 micrometer, is necessary.

Patent Application WO-A-02/065554 by Saint-Gobain Glass France teaches the provision of a relatively thin film of molybdenum (less than 500 nm) and the provision of one or more thin films impermeable to alkali metals between the substrate and the molybdenum-based thin film, so as to retain the qualities of the molybdenum-based thin film during the subsequent heat treatments.

The molybdenum thin film transforms into a Mo(S,Se)₂ thin film which gives a good ohmic contact. The thickness of this thin film however needs to be well controlled. Otherwise several problems can occur:
a. Power loss due to high resistance if too much of the back electrode is consumed.
b. Process issues in scribing and contacting in the P₂/ZnO/Mo contact, i.e. higher contact resistance.
c. Peeling-off of the thin film absorber
d. Non-uniformities in the absorber on a microscopic scale which may lead to reduction of efficiency.
e. Corrosion under hot and humid conditions of the Mo/MoSSe₂/ClS contact and the Mo/ MoSSe₂/ZnO contact in the scribe line P₂.

In WO-A-02/065554, aluminum or copper thin films are used in combination with relatively thick thin films of molybdenum of 175nm.

In addition to the selenization process, the back electrode needs to withstand the patterning processes. The P1 patterning process forms a trench within the conductive part of the back electrode.

P1 scribing can be performed by mechanical means or by ns or ps laser processes either from the top or through the glass. The requirements are a good electrical isolation between adjacent cells, no alkali barrier thin film damage as well as a smooth topography for good coverage of the subsequent thin films. Apart from P1, there are other patterning or film removal processes: the removal of the absorber and buffer thin film for the P2 patterning. Here the back electrode must resist against the patterning process in order to form the contact with the front electrode in the integrated interconnection. The patterning process P₂ can be either mechanical by scribing with a thin needle or by picosecond laser ablation from the top. In the case of mechanical patterning a low ductility metal may lead to partial removal of the back electrode within P2 which results in a high contact resistance. In case of laser patterning, the selective removal of the CIS absorber thin film from a low melting back electrode material may be difficult leading to shunts or loss of contact area. In the P3 process, the front electrode (ZnO) is separated between the different cells either by removing the ZnO only or by removing the ZnO plus absorber. The P3 process is typically a mechanical process. Here as well a soft back electrode material may lead to a partial removal of the back electrode. The fourth patterning step in the manufacturing process can be the removal of the TCO thin film and absorber adjacent to the first and the last cell for external contacting of the integrated solar cells with a bus bar though a soldering or welding process. This process is a mechanical step too, using brushing or scraping. Here again a soft back electrode material may cause problems by smearing or partial removal.

An object of the present invention is to provide a conductive and corrosion resistant back contact substrate, the manufacturing cost of which is relatively low, that can be selectively laser ablated or not for P1 and P2 scribing and that can withstand mechanical scribing.

To this end, a subject-matter of the present invention is in particular a back-contact substrate for a photovoltaic cell, comprising a carrier substrate and an electrode coating, the electrode coating comprising:
- a metallic thin film;
- a barrier to selenization thin film for protecting the metallic thin film, the barrier to selenization thin film having a thickness of at most 50 nm, preferably at most 30 nm, preferably at most 20 nm; and
- on the barrier to selenization thin film, an upper thin film based on a metal M capable of forming, after sulphurization and/or selenization, an ohmic contact thin film with a photoactive semiconducting material,
wherein the metallic thin film is based on aluminum and has a thickness of at most 300nm, preferably at most 100 nm, preferably at most 90 nm, preferably at most 80 nm.

Such a conducting substrate exhibits the advantage of making it possible to obtain, with reduced cost materials, a resistance per square equivalent to that of a conducting substrate, the electrode coating of which is composed of just one molybdenum thin film.

By virtue of the conducting substrate, the process for the manufacture of the photovoltaic cell (or photovoltaic module) is in addition particularly reliable. This is because the barrier to selenization thin film makes it possible both to guarantee the presence and the amount of Mo(S,Se)₂ by the transformation of all of the upper thin film (for example if its thickness is between 10 and 50 nm), while guaranteeing the presence and a uniform thickness of an aluminum-based thin film, the conductance properties of which have been retained. The retention of the qualities of the aluminum-based thin film and the uniformity of the thickness thereof make it possible to reduce the amounts of materials to the minimum. It was found that a resitivity below 5µOhm*cm can be obtained. With a thin film thickness of 60nm, a sheet resistance of 0,72 Ω was obtained, which is sufficient for solar cells with high efficiency.

The uniformity of the ohmic contact thin film formed by the upper thin film after selenization and/or sulphurization is additionally beneficial to the efficiency of the solar cell.

It was found that such a thin barrier to selenization thin film was suitable for protecting a metallic thin film with a material based on aluminum. Copper for example did not pass the test.

Also, with a thin aluminum-based thin film combined with a thin barrier to selenization and a molybdenum thin film, the electrode was able to pass a laser P1 scribing test. The electrode was expected to fail such a test considering its low melting point, in which case mechanical scribing would be necessary.

There is a considerable advantage to having a clear P1 scribing.

While increasing the thickness of the upper thin film 12 and the barrier to selenizeation thin film 10 avoids delamination around the P1 scribing trench. It was found that decreasing the thickness of the aluminum leads to better P1 scribing.

According to specific embodiments, the conducting substrate comprises one or more of the following characteristics, taken in isolation or according to all the combinations technically possible:
- the electrode is formed on the carrier substrate;
- the metallic thin film is formed on the carrier substrate;
- the metallic thin film has a thickness of at least 40 nm, preferably at least 50 nm, preferably at least 60nm;
- the electrode comprises a single metallic thin film between the barrier to selenization thin film and the carrier substrate;
- the metallic thin film is made of aluminum;
- said metallic thin film further contains one or more among the following additional elements: copper (Cu), nickel (Ni), platinum (Pt), molybdenum (Mo), manganese (Mn), magnesium (Mg), beryllium (Be), vanadium (V), Zinc (Zn), silicon (Si), with a total atomic content of at most 5%;
- said metallic thin film further contains oxygen (O) and/or nitrogen (N) with a total maximum atomic content of at most 5%;
- said metallic thin film has a resistivity of at most 15 µΩ.cm, preferably of at most 10 µΩ.cm, preferably at most 6 µΩ.cm;
- said metallic thin film has a sheet resistance below 2 Ω/□, preferably below 1 Ω/□;
- said barrier to selenization thin film is based on at least one among MoₓO_{y}N_{z}, TiₓO_{y}N_{z}, WₓO_{y}N_{z}, TaₓO_{y}N_{z}, NbₓO_{y}N_{z}, ReₓO_{y}N_{z};
- the barrier to selenization thin film is formed on the metallic thin film;
- the barrier to selenization thin film has a compressive stress between 0 and -10GPa, preferably between -1 and -5 GPa;
- the barrier to selenization thin film is nano-crystalline or amorphous with a grain size of at most 10nm;
- the barrier to selenization thin film has a molar composition O/(O+N) of at least 1% and at most 50%;
- the barrier to selenization thin film has a molar composition M'/(M'+O+N) of at least 15% and at most 80%;
- the barrier to selenization thin film has a thickness of at least 5 nm and at most 100nm, preferably at least 10nm and at most 60nm;
- said ohmic contact thin film is based on molybdenum (Mo) and/or tungsten(W);
- the ohmic contact thin film is formed on the metallic thin film and on the barrier to selenization thin film if present;
- the ohmic contact thin film is to be in contact with the photoactive thin film;
- said metal M is capable of forming a compound of semiconducting sulphide and/or selenide of p type capable of forming an ohmic contact with the photoactive semiconducting material;
- the back contact substrate further comprises a barrier to alkali thin film between the carrier substrate and the electrode;
- the barrier thin film is formed on the carrier substrate;
- the barrier to alkali thin film is based on at least one of: silicon nitride, silicon oxide, silicon oxynitride, silicon oxycarbide, aluminum oxide and aluminum oxynitrure.

Another subject-matter of the invention is a photovoltaic cell comprising a back contact substrate as described above and at least a thin film of a photoactive material.

According to a specific embodiment, said photoactive material is based on chalcogenide compound semiconductors for example a material of Cu(In,Ga)(S,Se)₂ type, in particular CIS,CIGS, CIGSSe or also a material of Cu₂(Zn,Sn)(S,Se)₄ type.

Another subject-matter of the invention is a process for the manufacture of a back-contact substrate for a photovoltaic cell, comprising at least steps of:
- making a metallic thin film;
- making a barrier to selenization thin film for protecting the metallic thin film, the barrier to selenization thin film having a thickness of at most 50 nm, preferably at most 30 nm, preferably at most 20 nm; and
- on the barrier to selenization thin film, making an upper thin film based on a metal M capable of forming, after sulphurization and/or selenization, an ohmic contact thin film with a photoactive semiconducting material,
   wherein the metallic thin film is based on aluminum and has a thickness of at most 300nm, preferably at most 100 nm, preferably at most 90 nm, preferably at most 80 nm.

According to a specific embodiment, the process comprises a laser ablation step for forming a P1 scribing into the back contact susbtrate.

Another subject-matter of the inventin is a process for the manufacture of a photovoltaic cell on a back contact substrate as described above, comprising a step of formation of a photoactive thin film during which the ohmic contact thin film is transformed into a sulphide and/or a selenide of said metal M.

According to a specific embodiment, the process comprises a laser ablation step for forming a P1 scribing into the back contact susbtrate.

Another subject-matter of the invention is a photovoltaic module comprising a plurality of photovoltaic cells connected to one another in series and all formed on the same substrate, in which the photovoltaic cells are as described above.

A better understanding of the invention will be obtained on reading the description which will follow, given solely by way of example and made with reference to the appended drawings, in which:
- Fig.1 is a schematic cross section of a back contact for a solar cell,
- Fig.2 is a schematic cross section of a soplar cell made with the back contact of Fig.1;
- Fig.3 shows three top view photographs of different back contacts after selenization;
- Fig.4a is a diagram showing mass gain after selenization for different stacks and Fig.4B is a photograph analogous to those of Fig.3;
- Fig.5 shows SEM cross sections of two CIGSSe absorbers with two different back contacts;
- Fig.6 shows microscope images of P1 patterning lines with Al thicknesses of 130nm (a) and 65nm (b); and
- Fig.7 is a diagram showing lift-off height at the edges of P1 trenches in glass/ Si₃N₄/ Al/ TiON/ Mo stacks determined by confocal microscopy as a function of the aluminum layer thickness.

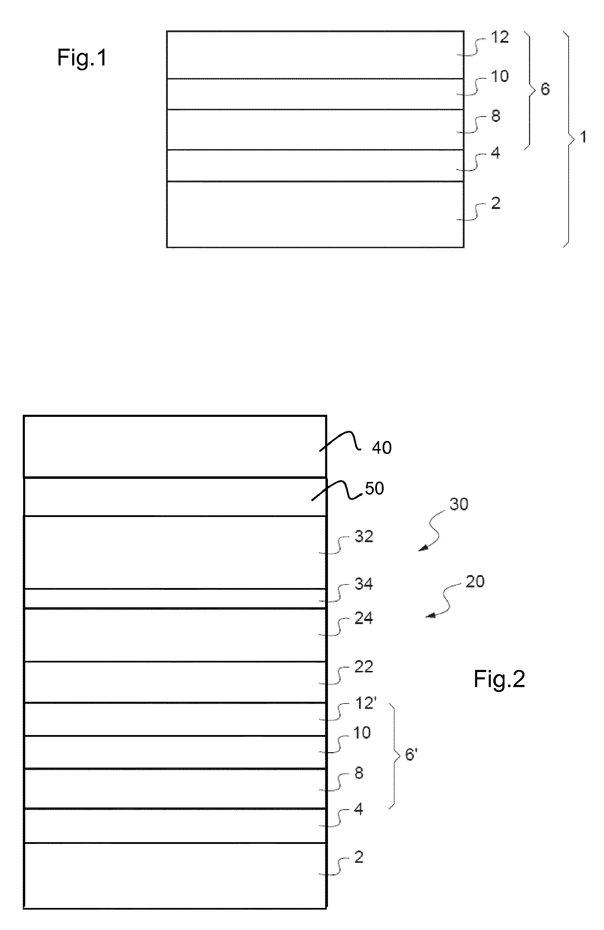

The drawings in Figs. 1 and 2 are not to scale, for a clear representation, as the differences in thickness between in particular the carrier substrate and the thin films deposited are significant, for example of the order of a factor of 500.

Fig. 1 illustrates a back contact substrate 1 for a photovoltaic cell comprising:
- a carrier substrate 2, for example made of glass;
- a barrier to alkali thin film 4 formed on the substrate 2; and
- an electrode 6 formed on the barrier to alkali thin film 4.

Throughout the text, the expression "A formed (or deposited) on B" is understood to mean A is formed either directly on B and thus in contact with B or formed on B with interposition of one or more thin films between A and B.

It should be noted that, throughout the text, the term "electrode" is understood to mean an electrical current transport coating comprising at least one thin film which conducts electrons, that is to say having a conductivity which is provided by the mobility of electrons.

It should also be noted that, throughout the text, it is hereby meant by "a material based on A" that the material is mainly made of A, so that its aimed function is fulfilled. It preferably contains at least 80% atomic percent of A, for example at least 90% atomic percent of A. If the material is "based on A and B", it is meant that it preferably contains at least 80% total atomic percent of A and B, for example at least 90% total atomic percent of A and B.

It is meant by "total atomic content" that the atomic contents of the elements are added. If the atomic content of A is 35% and the atomic content of B is 55%, the total atomic content of A and B is 90%.

In addition, throughout the text, the expression "comprises a thin film" should, of course, be understood as "comprises at least one thin film".

The barrier to alkali thin film 4 is, for example, based on one of: silicon nitride, silicon oxide, silicon oxynitride, silicon oxycarbide, aluminum oxide or aluminum oxynitride, as will be further explained below.

The electrode 6 illustrated is composed:
- of a metallic thin film 8 formed directly on the barrier to alkali thin film 4;
- of a barrier to selenization thin film 10, formed directly on the metallic thin film 8; and
- of an upper thin film 12 based on a metal M capable of forming, after sulphurization and/or selenization, an ohmic contact thin film with a photoactive semiconducting material, formed directly on the barrier to selenization thin film 10.

The metallic thin film 8 forms a main conductive coating of the electrode. It is essential for achieving the required conductance of the electrode 6 and will be further explained in detail below. The main conductive coating may comprise only the metallic thin film or several thin films including the metallic thin film.

Importantly, the metallic thin film is based on aluminum, and the metallic thin film 8 has a thickness of at most 300nm, preferably at most 100 nm, preferably at most 90 nm, preferably at most 80 nm.

It should be noted that, throughout the text, the term "only one thin film" is understood to mean a thin film of one and the same material. This single thin film can nevertheless be obtained by the superposition of several thin films of one and the same material, between which exists an interface which it is possible to characterize, as described in WO-A-2009/080931.

As will be further explained below, the metallic thin film 8 is based on aluminum.

The barrier to selenization thin film 10 protects the metallic thin film 8 from selenization. It is, for example, a thin film of a metal nitride or oxynitride such as TiOₓN_{y}, MoOₓN_{y}, ZrOₓN_{y}, TaOₓN_{y}, AlOₓN_{y} or of a metal oxide such as MoOₓ or TiOₓ.

Importantly also, the barrier to selenization thin film has a thickness of at most 50 nm, preferably at most 30 nm, preferably at most 20 nm.

The ohmic contact thin film 12 is for establishing a good electrical contact with the light absorbing chalogenide thin film to be deposited directly above. It is for example based on molybdenum or tungsten, before selenization.

The barrier to selenization thin film 10 and the ohmic contact thin film 12 will be further explained below.

Such a back contact substrate 1 is intended for the manufacture of a photoactive material with addition of sodium. This element is known to improve the performance of photoactive materials of CIS, CIGS or CIGSSe type. As the sodium content is a key parameter in the process, the sodium migration from the glass towards the photoactive material needs to be controlled and so, the presence of an alkali barrier film 4 can be needed. In the case where the substrate does not comprise alkali species or as impurity, the barrier to alkali thin film 4 can be omitted. By "alkali", it is meant "alkali element" whatever its oxidation state, i.e. in metallic or ionic form. A typical glass substrate is for example, a soda-lime-silica glass and comprises sodium ions.

Another technique for the manufacture of the photoactive material consists in using the migration of the sodium ions from the carrier substrate, for example made of glass, in order to form the photoactive material. In this case, the back contact substrate 1 does not have a barrier to alkali thin film 4 and the metallic thin film 8 is, for example, formed directly on the carrier substrate 2.

In an alternative form also, the electrode 6 comprises one or more inserted thin films.

Thus, generally, the back contact substrate 1 comprises a carrier substrate 2 and an electrode 6 comprising:
- a metallic thin film 8 formed on the carrier substrate 2, the metallic thin film 8 being based on aluminum and having a thickness of at most 300nm, preferably at most 100 nm, preferably at most 90 nm, preferably at most 80 nm;
- a barrier to selenization 10 formed on the metallic thin film 8 and having a thickness of at most 50 nm, preferably at most 30 nm, preferably at most 20 nm; and
- an upper thin film 12 based on a metal M capable of forming, after sulphurization and/or selenization, an ohmic contact thin film with a photoactive semiconducting material, the upper thin film being formed on the barrier to selenization thin film 10.

### Metallic thin film

As explained above, the metallic thin film 8 is for conducting the electrical current along the surface of the electrode 6, to the connectors.

It is a single thin film based on aluminum, preferably made of aluminum.

The mettalic thin film 8 has, for example, an atomic content of aluminum of at least 90%, for example of at least 95%.

It is preferably pure. This is why it preferably contains one or more among the following additional elements: copper(Cu), nickel (Ni), platinum (Pt), molybdenum (Mo), beryllium (Be), ,manganese (Mn), magnesium (Mg), vanadium (V), Zinc (Zn), silicon (Si), with a total atomic content of at most 5%. These metals are for example additives for increasing the hardness or byproducts of the metallurgical processes (mining, refining, target manufacturing)

Also, the metallic thin film 8 contains oxygen (O) and/or nitrogen (N) with a total maximum atomic content of at most 5%, preferably at most 2%.

In order to reduce manufacturing costs for solar modules the thickness of the metal film should be as low as possible. Using very thin films not only the materials cost can be reduced but also the throughput of the deposition equipment and hence cost of the manufacturing equipment itself. On the other hand the sheet resistance of the back electrode should be sufficiently high in order to reduce ohmic losses that would limit the efficiency of the solar cell or module.

Importantly, the metallic thin film 8 has a thickness of at most 300nm, preferably at most 100 nm, preferably at most 90 nm, preferably at most 80 nm.

Preferably also, its thickness is at least 40 nm, preferably at least 50 nm, preferably at least 60nm.

The metallic thin film 8 has a resistivity of at most 15 µΩ.cm, preferably of at most 10 µΩ.cm, preferably at most 6 µOhmcm.

The metallic thin film 8 has preferably a sheet resistance below 2 Ω/□, preferably below 1 Ω/□.

### Barrier to selenization thin film

The barrier to selenization thin film 10 further protects the metallic thin film 8 from possible selenization and/or sulphurization. It should be noted that a thin film which protects from selenization also protects from sulphurization.

The term "barrier thin film to selenization" is understood to mean a thin film of a material of any type capable of preventing or reducing the selenization of thin films covered with the barrier to selenization during the deposition, on the barrier to selenization, of thin films of semiconducting materials formed by selenization and/or sulphurization. The barrier to selenization within the meaning of the invention shows a proven effectiveness even at a thickness of 3 nm.

A selenization possible test for determining if a material is suitable or not for a role as barrier to selenization is to compare a sample with and without a thin film of 5 nm of this material between the ohmic contact thin film 12 and the metallic thin film 8 and to subject the samples to a selenization, for example by heating at 520°C in a 100% selenium atmosphere at atmospheric pressure during 10 minutes. If the selenization of the metallic thin film 8 is reduced or prevented and the ohmic contact thin film 12 is entirely selenized, the material is effective.

The material of the barrier to selenization thin film 10 is, for example, based on a metal nitride or oxynitride M'ON such as TiOₓN_{y}, MoOₓN_{y}, WOₓN_{y}, NbOₓN_{y}, ReOₓN_{y} ZrOₓN_{y}, TaOₓN_{y}, AlOₓN_{y} or of a metal oxide such as MoOₓ or TiOₓ.

Generally, it is a material of any type suitable for protecting the metallic thin film 8 from a possible selenization or sulphurization.

The material can also be based on a metal oxide, such as molybdenum oxide, titanium oxide or a mixed oxide of molybdenum and titanium.

However, the oxynitrides are preferred to the oxides.

More preferably, it concerns a material based on at least one among MoₓO_{y}N_{z}, WₓO_{y}N_{z}, TaₓO_{y}N_{z}, NbₓO_{y}N_{z}, ReₓO_{y}N_{z},even more preferably MoₓO_{y}N_{z}.

The barrier to selenization thin film has preferably a compressive stress between 0 and -10GPa, preferably between -1 and -5 GPa.

The barrier to selenization thin film is also preferably nano-crystalline or amorphous with a grain size of at most 10nm.

Alternatively, nitrides could also be used for all of the above listed materials, i.e. x=0. MoN was most often used in the experiments.

It may also be based on several metal oxynitrides MON, M'ON, etc.
or several nitrides.

It should be noted that the above nitrides, oxides and oxynitrides can be substoichiometric, stoichiometric or superstoichiometric respectively in nitrogen and oxygen.

Preferably though, in the case of oxynitrides, the barrier to selenization thin film has a molar composition O/(O+N) of at least 1 % and at most 50%.

Preferably also, the barrier to selenization thin film has a molar composition M'/(M'+O+N) of at least 15% and at most 80%.

The barrier to selenization 10 has a thickness of less than or equal to 100 nm, preferably of less than or equal to 60 nm, more preferably of less than or equal to 40 nm.

If the barrier to selenization 10 is very thin, there is a risk of it no longer having a significant effect. It thus has, for example, a thickness of at least 5 nm, preferably of at least 10 nm. The barrier to selenization 10 has a lower conductivity than the metallic thin film 8. For example, it has a resistivity of between 200 µohm.cm and 1000 µohm.cm, in the case of a thin film based on a metal oxide, nitride or oxynitride.

As a result of the slight thickness of the barrier to selenization 10, a high resistivity is not harmful to the performance of the cell, the electrical current passing transversely.

The barrier to selenization 10 is, in addition, preferably capable of limiting the backward diffusion of the sodium ions towards the carrier substrate 2, that is to say the diffusion of the sodium ions from the top of the ohmic contact thin film 12 through the ohmic contact thin film 12 and towards the carrier substrate 2.

This property is advantageous in several respects.

It renders more reliable the manufacturing processes consisting in adding alkali metals in order to form the photoactive material, for example by deposition of a sodium compound on the ohmic contact thin film 12 of the electrode 6 or by addition of a sodium compound during the deposition of the photoactive material, for example using targets comprising sodium or other alkali metals, as described in US-B-5 626 688.

### Ohmic contact thin film

The metal M used for the ohmic contact thin film 12, is capable of forming, after sulphurization and/or selenization, an ohmic contact thin film with a photoactive semiconducting material, in particular with a photoactive semiconducting material based on copper and selenium and/or sulphur chalcopyrite, for example a photoactive material of Cu(In,Ga)(S,Se)₂ type, in particular CIS or CIGS, CIGSSe, or also a material of Cu₂(Zn,Sn)(S,Se)₄ type or a material of cadmium telluride (CdTe) or cadmium sulphide (CdS) types.

The term "an ohmic contact thin film" is understood to mean a thin film of a material such that the current/voltage characteristic of the contact is nonrectifying and linear.

Preferably, the ohmic contact thin film 12 is the final ohmic contact thin film of the electrode 6, that is to say that the electrode 6 does not have another thin film above the thin film 12.

The thin film 12 is intended to be fully transformed, by selenization and/or sulphurization, into Mo(S,Se)₂, which material is not, on the other hand, regarded as a material "based on elemental molybedenum" but a material based on molybdenum disulphide, on molybdenum diselenide or on a mixture of molybdenum disulphide and diselenide.

Conventionally, the notation (S,Se) indicates that this concerns a combination of SₓSe₁₋ₓ with 0 ≤ *x* ≤ 1.

It should be noted that the substrate illustrated in Figure 1 and described above is an intermediate product in the manufacture of a photovoltaic cell or module. This intermediate product is subsequently transformed as a result of the process for the manufacture of the photoactive material. The back contact substrate 1 described above is understood as the intermediate product before transformation, which can be stored and dispatched to other production sites for the manufacture of the module.

The ohmic contact thin film 12, so as to act as ohmic contact once transformed into Mo(S,Se)₂, for example has a thickness of at least 10 nm and at most 100 nm before selenization, preferably of at least 30 nm and at most 50 nm. A large thickness is not necessary. After selenization, Mo(S,Se)₂ has a thickness which is 3-4 times the thickness of the initial molybdenum thin film.

The said metal M is advantageously molybdenum-based and/or tungsten-based.

The molybdenum disulphide and/or diselenide compounds Mo(S,Se)₂ are materials having a proven effectiveness as ohmic contact thin film. Tungsten (W) is a material with similar chemical properties. It also forms chalcogenide semiconductors WS₂ and WSe₂. Mo(S,Se)₂ and W(S,Se)₂ can both be formed as p type semiconductors. More generally still, it concerns a metal M of any type capable of forming, after sulphurization and/or selenization, an ohmic contact thin film with a photoactive semiconducting material, more particularly with a photoactive material based on copper and selenium and/or sulphur chalcopyrite.

### Carrier substrate

The carrier substrate 2 and the barrier to alkali 4 will now be described. The carrier substrate can be rigid or flexible and can be made of a variety of materials such as soda-lime-silica or borosilicate glass, ceramic sheets, metal films, or polymer films.

Two cases may be distinguished: the case where alkali are added on the back contact substrate during or before the formation of the absorber thin film (first case) and the case where only migration of alkali from the carrier substrate is used for doping the absorber thin film (second case).

The substrates provided with one or more barrier to alkali thin films 4 (i.e. a barrier to the diffusion of alkalispecies ) are used in the first case, in particular in order to make it possible to use, as substrate, a sheet of glass of soda-lime-silica type obtained by the float process, glass of relatively low cost which exhibits all the qualities which are known in this type of material, such as, for example, its transparency, its impermeability to water and its hardness.

The content of alkali species of the substrate 2 is, in this case, a disadvantage which the barrier to alkali thin film 4 will minimize, since only alkali from the addition on the back contact substrate and in a controlled amount are wanted.

The barrier to alkali 4 is preferably based on at least one of the materials chosen from: silicon nitride, silicon oxide, silicon oxynitride, silicon oxycarbide, a mix of silicon oxycarbide and silicon oxynitride, aluminum oxide or aluminum oxynitride.

Alternatively, a soda-lime-silica glass substrate is used without a barrier to alkali thin film but the alkali mobility is reduced by a matrix adaptation to benefit of the so-called mixed-alkali effect. The sodium content that may diffuse through the electrode to dope the photoactive material is significantly reduced and alkali are added during or before formation of the absorber thin film.

In an alternative form, still in the first case, the carrier substrate 2 is a sheet of a material of any appropriate type not comprising alkali species, for example a silica-based glass not comprising alkali species such as borosilicate glasses, high-strain point glass or made of plastic, or even of metal.

In the second case (no addition of alkali), the carrier substrate 2 is of any appropriate type comprising alkali species, for example comprising sodium ions and potassium ions.

The substrate is, for example, a soda-lime-silica glass. The barrier to alkali thin film is absent.

In both cases, the carrier substrate 2 is intended to act as back contact in the photovoltaic module once the electrode is formed on it and thus does not need to be transparent. The sheet constituting the carrier substrate 2 can be flat or rounded, and can exhibit dimensions of any type, in particular at least one dimension of greater than 1 meter.

### Manufacturing Process

Another subject-matter of the invention is a process for the manufacture of the back contact substrate 1 described above.

The process comprises the stages consisting in:
- depositing the metallic thin film 8 on the carrier substrate 2, with optional prior deposition of the barrier to alkali thin film 4 and /or optional prior deposition of the adhesion thin film;
- depositing the barrier to selenization thin film 10 on the metallic thin film 8, for example directly on it or with interposition of an intermediate thin film;
- depositing the ohmic contact thin film 12 based on the metal M on the barrier to selenization thin film 10, and transforming the said thin film based on metal M into a sulphide and/or selenide of the metal M. This transformation stage can be a separate stage before the formation of the CIS, CIGS or CZTS semiconducting thin film or a stage carried out during the selenization and/or sulphurization of the CIS, CGS or CZTS semiconducting thin film, whether this selenization and/or sulphurization is carried out during the deposition of the said semiconducting thin film or after deposition of metal components said to be precursors of the semiconducting thin film.

The deposition of the various thin films is, for example, carried out by magnetron cathode sputtering but, in an alternative form, another process of any appropriate type is used, e.g. thermal evaporation, chemical vapor deposition or electrochemical deposition.

### Photovoltaic Cell

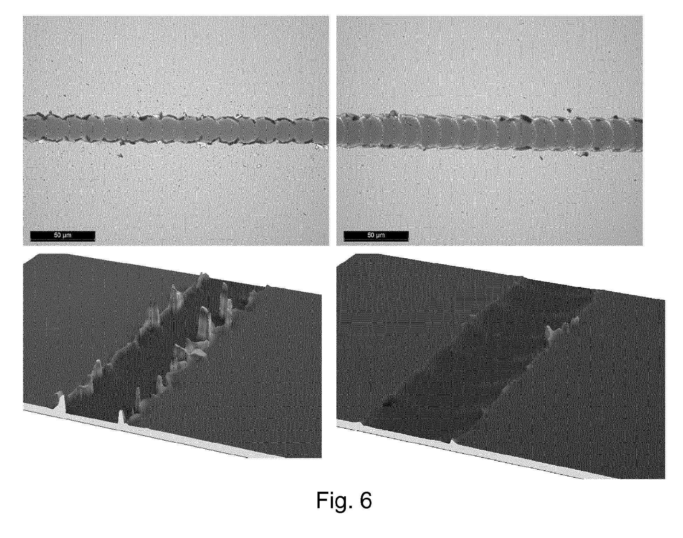

Another subject-matter of the invention is a semiconductor device 20 (Figure 6) which uses the back contact substrate 1 described above to form one or more photoactive thin films 22, 24 thereon.

The first photoactive thin film 22 is typically a doped thin film of p type, for example based on copper Cu, indium In, and selenium Se and/or sulphur S chalcopyrite. It can be, for example, as explained above, CIS, CIGS, CIGSSe or CZTS.

The second photoactive thin film 24 is doped, of n type and described as buffer. It is, for example, composed of CdS (cadmium sulphide) and is formed directly on the first photoactive thin film 22.

In an alternative form, the buffer thin film 24 is, for example, based on InₓS_{y}, Zn(O,S) or ZnMgO or is made of another material of any appropriate type. In an alternative form again, the cell does not comprise a buffer thin film and the first photoactive thin film 22 itself forms a p-n homojunction.

Generally, the first photoactive thin film 22 is a thin film of p type or having a p-n homojunction obtained by addition of alkali metal elements.

The deposition of the photoactive thin film comprises stages of selenization and/or sulphurization, as explained in more detail below. The deposition can be carried out by evaporation of the elements Cu, In, Ga and Se (or Cu, Sn, Zn, S). During these selenization and/or sulphurization stages, the ohmic contact thin film 12 based on the metal M is transformed into a thin film 12' based on M(S,Se)₂. This transformation concerns, for example, the whole of the ohmic contact thin film 12.

The semiconducting device 20 thus comprises:
- the carrier substrate 2 and the electrode 6' formed on the carrier substrate 2, the ohmic contact thin film 12' of which has been transformed.

The electrode 6' comprises:
- the metallic thin film 8;
- the barrier to selenization thin film 10 formed on the metallic thin film 8; and
- the ohmic contact thin film 12', based on M(S,Se)₂, formed on the barrier to selenization 10. The semiconducting device comprises, on the ohmic contact thin film 12' and in contact with the latter, the photoactive semiconducting thin film(s) 14, 16.

Another subject-matter of the invention is a photovoltaic cell 30 comprising a semiconducting device 20 as described above.

The cell comprises, for example, as illustrated in Figure 6:
- the semiconducting device 20 formed by the thin films 8, 10, 12', 22 and 24;
- a transparent electrode 32, for example made of ZnO:Al, formed on the first photoactive thin film 22 and on the buffer thin film 24, in the event of the presence of the latter, with optional interposition, between the transparent electrode 32 and the semiconducting device 20, of a resistive thin film 34, for example of intrinsic ZnO or of intrinsic ZnMgO.

The transparent electrode 32 comprises, in an alternative form, a thin film of zinc oxide doped with gallium or boron, or also an indium tin oxide (ITO) thin film.

Generally, it is a transparent conducting material (TCO) of any appropriate type.

The transparent electrode 32 is the so-called front electrode. As a reminder, in a photovoltaic cell or module, the back electrode 6 is the electrode placed after the absorber thin film on the path of incoming light and the front electrode the one placed before. This is why a carrier substrate 2 with a back electrode 6 deposited on it is called a back contact substrate.

For a good electrical connection and good conductance, a metal grid (not represented) is subsequently optionally deposited on the transparent electrode 32, for example through a mask, for example by an electron beam. It is, for example, an Al (aluminum) grid, for example with a thickness of approximately 2 µm, on which is deposited a Ni (nickel) grid, for example with a thickness of approximately 50 nm, in order to protect the Al thin film.

The cell 30 is subsequently protected from external attacks. It comprises, for example, to this end, a counter-substrate 40 covering the front electrode 32 and laminated to the coated substrate, i.e. to the front electrode 32, via a lamination foil 50 made of a thermoplastic polymer. It is, for example, a sheet of EVA, PU or PVB.

Another subject-matter of the invention is a photovoltaic module comprising several photovoltaic cells formed on the same substrate 2, which cells are connected to one another in series and are obtained by subsequent patterning and coating of the thin films of the semiconducting device 20. This monolithic integration of up to 100 individual cells is the state of the art for large area commercial thin film modules. It also includes the making of one to more than 100 laser P1 scribing trenches through the ohmic contact thin film 12, the barrier to selenization thin film 10 and the metallic thin film 8.

Another subject-matter of the invention is a process for the manufacture of the semiconducting device 20 and of the photovoltaic cell 30 above, which process comprises a stage of formation of a photoactive thin film by selenization and/or sulphurization.

Numerous known processes exist for the manufacture of a photoactive thin film of Cu(In,Ga)(S,Se)₂ type. The photoactive thin film 22 is, for example, a CIGS or CIGSSe thin film formed in the following way.

In a first stage, the precursors of the thin film are deposited on the electrode 6.

A metal stack composed of an alternation of thin films of CuGa and In type is, for example, deposited on the electrode 6 by magnetron cathode sputtering at ambient temperature. A thin film of selenium is subsequently deposited at ambient temperature directly on the metal stack, for example by thermal evaporation.

In an alternative form, the metal stack has, for example, a multilayer structure of Cu/In/Ga/Cu/In/Ga... type.

In a second stage, the substrate is subjected to a heating treatment at high temperature, referred to as RTP ("Rapid Thermal Process"), for example at approximately 520°C, in an atmosphere composed, for example, of gaseous sulphur, for example based on S or H₂S, thus forming a thin film of CuInₓGa₁₋ₓX(S,Se)₂.

One advantage of this process is that it does not require an external source of selenium vapour. The loss of a portion of the selenium during the heating is compensated for by an excess deposition of selenium on the metal stack. The selenium necessary for the selenization is provided by the deposited thin film of selenium.

In an alternative form, the selenization is obtained without the deposition of a thin film of selenium but by an atmosphere comprising gaseous selenium, for example based on Se or H₂Se, prior to the exposure to an atmosphere rich in sulphur.

As explained above, it can be advantageous to deposit a thin film based on alkali species, for example on sodium, for exact dosing of the sodium in the photoactive thin film.

Prior to the deposition of the CuGa and In metal stack, the alkali species are, for example, introduced by the deposition, on the sacrificial molybdenum-based thin film 12, of a thin film of sodium selenide or of a compound comprising sodium, so as to introduce, for example, of the order of 2 × 10¹⁵ sodium atoms per cm². The metal stack is deposited directly on this thin film of sodium selenide.

CZTS may also be formed with a similar process.

It should be noted that there exists numerous possible alternative forms for forming the CI(G)S or CZTS thin films, which alternative forms include, for example, the co-evaporation of the above mentioned elements, chemical vapour deposition, electrochemical deposition of metals, selenides or chalcopyrites, reactive sputtering of metals or selenides in the presence of H₂Se or H₂S.

Generally, the process for the manufacture of the photoactive thin film 22 is of any appropriate type.

An important aspect of the invention is that the electrode has reached its final properties after deposition and is compatible with low temperature processes and high temperature processes.

### EXAMPLES AND RESULTS

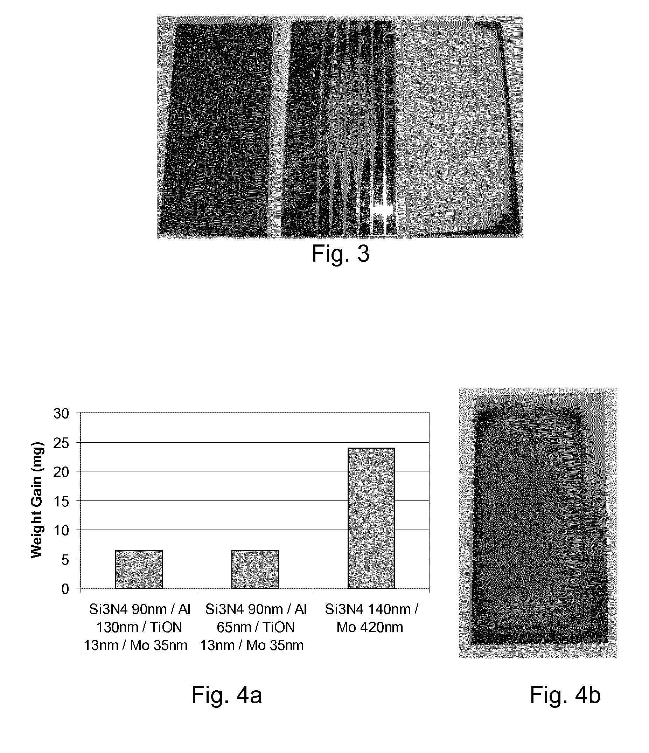

The effect of a selenization barrier using a Cu base electrode was investigated, compared to molybedenum and aluminum. A thin barrier to selenization could not withstand the selenization process. As a test samples coated with different back electrode thin film systems were exposed to a high selenium partial pressure at temperatures above 500°C. In Fig. 3, the picture on the left corresponds a stack of glass/ Si₃N₄(140nm)/ Mo(200nm)/ TiON(15nm)/ Mo(30nm) stack, the one in the centre corresponds to a glass/ Si₃N₄(140nm)/ Cu(100nm)/ MoON(15nm)/ Mo(30nm) and the picture on the right is a glass/ Si₃N₄(140nm)/ Mo(400nm) stack. As can be seen, the molybdenum thin film can be sufficiently protected with thin films of TiON. Further analysis (not shown here) confirms that thin films of MoN also sufficiently protect molybdenum base thin films. The unprotected Mo thin film (right) was fully selenized and delaminated from the glass/ Si₃N₄ substrate. The thin film stack of glass/ Si₃N₄(140nm)/ Cu(100nm)/ MoN(15nm)/ Mo30nm (centre) has been non-uniformly selenized, particularly in the P1 patterning lines and in many small spots in the cell area.

Using aluminum, the selenization test showed that Al could be sufficiently protected by a thin TiON thin film (Fig. 4): in this test, which shows mass gain after selenization for three different stacks, and thus resistance to selenization, the weight gain of the protected Al/TiON/Mo thin films is a factor of 4 lower than the unprotected Mo thin films (Figure 4a). The reference of Molybdenum (on the right) did not peel off. Also, the aluminum thin films did not delaminate, -see photo in Fig. 4b, which shows a photograph after selenization test of glass/Si3N4(90nm)/ Al(65nm)/ TiON(13nm)/ Mo(35nm)-. The degree of selenization can therefore be directly expressed by the weight difference before and after selenization. The weight gain is due to the selenium bound in the MoSe₂ thin film.

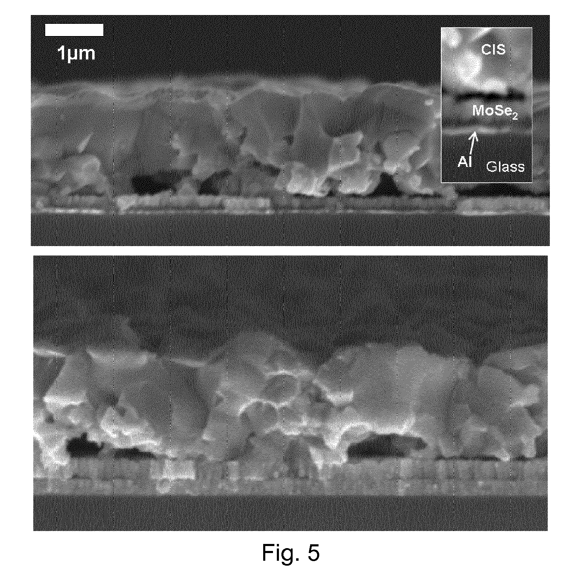

Fig.5 shows SEM cross sections of CIGSSe absorbers:
Top picture: back electrode with glass/ Si₃N₄/ Al(120nm)/ TiON(10nm)/ Mo(35nm) (Mo selenized to MoSSe₂)
Bottom picture: back electrode with glass/ Si₃N₄/ Mol(220nm)/ TiON(10nm)/ Mo2(55nm), Mo1 is the first thin film of Mo and Mo2 the second thin film of Mo, Mo2 is selenized to MoSSe₂

The protection by thin TiON thin film is confirmed by the SEM cross section images of Fig. 5, both for Si₃N₄/Al/TiON/Mo and Si₃N₄/Mo1/TiON/Mo2, the base thin film remains unchanged.

### Thickness of the Aluminum thin film:

Table I shows examples of aluminum thin films and complete back electrodes stacks comprising the alkali barrier, the aluminum thin film, the barrier to selenization thin film and the Mo top thin film. Using appropriate starting materials and optimized process conditions, resitivity values below 5µOhmcm can be obtained for example by magnetron sputtering. For a sheet resistance below 0,75 Ohm, which is preferred for high efficient solar cells, thickness values as low as 65nm are sufficient. For a back electrode using only a single molybenum thin film, a thickness of at least 200nm is required. Considering the much lower market price of aluminum metal and the low value of required thickness the cost of the back electrode is strongly reduced.

**Table I**

| Stack on soda lime glass | Sheet resistance | Resistivity Al |
|---|---|---|
| Al 84nm | 0,51 | 4,3 µΩ.cm |
| Si3N4 90nm / Al 84nm | 0,54 | 4,5 µΩ.cm |
| Si3N4 90nm / Al 130nm / TiN 13nm / Mo 35nm | 0,36 Ω | 4,6 µΩ.cm |
| Si3N4 90nm / Al 97nm / TiN 13nm / Mo 35nm | 0.46 Ω | 4,6 µΩ.cm |
| Si3N4 90nm / Al 65nm / TiN 13nm / Mo 35nm | 0.72 Ω | 4,6 µΩ.cm |

Surprisingly the use of thin films has turned out to yield other important advantages in addition to the materials cost. Fig. 6 shows microscope images of P1 patterning lines with Al thicknesses of 130nm (a) and 65nm (b).

Top row: light microscopy images, bottom row: confocal microscope height profile maps.
Left: glass/ Si₃N₄/ Al(130nm)/ TiON(15nm)/ Mo(30nm);
Right: glass/ Si₃N₄/ Al(65nm)/ TiON(15nm)/ Mo(30nm).

The thicker thin film showed a large rim or lift-off on both edges of the P1 trench. Such a rim could lead to a disturbed growth of the subsequent thin films or could lead to shunting within the solar cell. The lift-off should be significantly smaller than the thickness of the absorber thin film (1-2µm) in order to ensure a continuous coating.

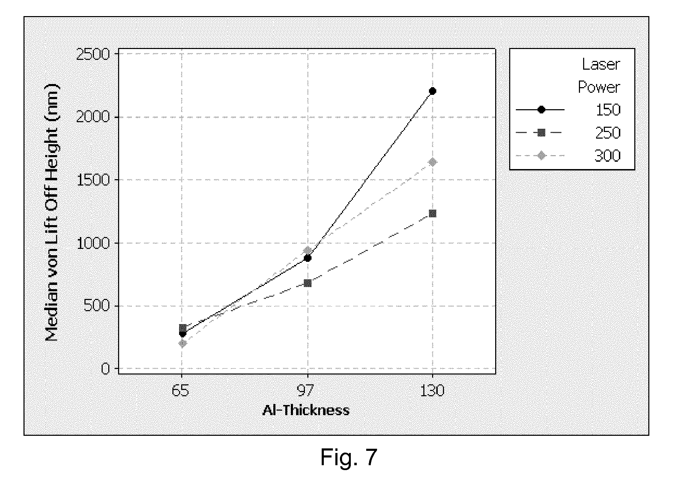

Fig.7 shows lift-off height at the edges of P1 trenches in glass/ Si₃N₄/ Al/ TiON/ Mo stacks determined by confocal microscopy as a function of the aluminum layer thickness. The lift-off strongly decreased with aluminum thin film thickness. The decrease is not trivial as in some cases a reduction of the thickness by a factor of 2 leads to a reduction of lift-off height by a factor of 4.

## Claims

1. Back-contact substrate (1) for a photovoltaic cell, comprising a carrier substrate (2) and an electrode coating (6), the electrode coating comprising:
- a metallic thin film (8);
- a barrier to selenization thin film (10) for protecting the metallic thin film (8), the barrier to selenization thin film (10) having a thickness of at most 50 nm, preferably at most 30 nm, preferably at most 20 nm; and
- on the barrier to selenization thin film(10), an upper thin film (12) based on a metal M capable of forming, after sulphurization and/or selenization, an ohmic contact thin film with a photoactive semiconducting material,
wherein the metallic thin film (8) is based on aluminum and has a thickness of at most 300nm, preferably at most 100 nm, preferably at most 90 nm, preferably at most 80 nm.

2. Back-contact substrate (1) according to claim 1, wherein the metallic thin film has a thickness of at least 40 nm, preferably at least 50 nm, preferably at least 60nm.

3. Back contact substrate (1) according to any preceding claim, wherein the electrode comprises a single metallic thin film between the barrier to selenization thin film and the carrier substrate.

4. Back contact substrate (1) according to any preceding claim, wherein the metallic thin film is made of aluminum.

5. Back contact substrate (1) according to any preceding claim, wherein said metallic thin film further contains one or more among the following additional elements: copper (Cu), nickel (Ni), platinum (Pt), molybdenum (Mo), manganese (Mn), magnesium (Mg), beryllium (Be), vanadium (V), Zinc (Zn), silicon (Si), with a total atomic content of at most 5%

6. Back contact substrate (1) according to any preceding claim, wherein said metallic thin film further contains oxygen (O) and/or nitrogen (N) with a total maximum atomic content of at most 5%.

7. Back contact substrate (1) according to any preceding claim, wherein said metallic thin film has a resistivity of at most 15 µΩ.cm, preferably of at most 10 µΩ.cm, preferably at most 6 µΩ.cm.

8. Back contact substrate (1) according to any preceding claim, wherein said metallic thin film has a sheet resistance below 2 Ω/□, preferably below 1 Ω/□.

9. (see claim 7)Back contact substrate (1) according to any preceding claim, wherein said barrier to selenization thin film is based on at least one among M_{Ox}O_{y}N_{z}, TiₓO_{y}N_{z}, WₓO_{y}N_{z}, TaₓO_{y}N_{z}, NbₓO_{y}N_{z}, ReₓO_{y}N_{z}.

10. Back contact substrate (1) according to any preceding claim, wherein said ohmic contact thin film is based on molybdenum (Mo) and/or tungsten(W).

11. Photovoltaic cell (20) comprising a back contact substrate (2) according to any preceding claim and at least a thin film of a photoactive material.

12. Process for the manufacture of a back contact substrate (1) for a photovoltaic cell (30), comprising at least steps of:
- making a metallic thin film (8);
- making a barrier to selenization thin film (10) for protecting the metallic thin film (8), ), the barrier to selenization thin film (10) having a thickness of at most 50 nm, preferably at most 30 nm, preferably at most 20 nm; and
- on the barrier to selenization thin film(10), making an upper thin film (12) based on a metal M capable of forming, after sulphurization and/or selenization, an ohmic contact thin film with a photoactive semiconducting material,
wherein the metallic thin film (8) is based on aluminum and has a thickness of at most 300nm, preferably at most 100 nm, preferably at most 90 nm, preferably at most 80 nm.

13. Process according to claim 12, comprising a laser ablation step for forming a P1 scribing into the back contact susbtrate.

14. Process for the manufacture of a photovoltaic cell (20) on a back contact substrate according to any of claims 1 to 11, comprising a step of formation of a photoactive thin film (22) during which the ohmic contact thin film is transformed into a sulphide and/or a selenide of said metal M.

15. Process according to claim 14, comprising a laser ablation step for forming a P1 scribing into the back contact susbtrate.
